# FASCICULE DE BREVET EUROPEEN

(11) **EP 2 242 343 B1**
(45) Date de publication et mention de la délivrance du brevet: **20.06.2012**
(21) Numéro de dépôt: 10159537.9
(22) Date de dépôt: 09.04.2010
(51) Int. Cl.: H05K 7/14

(54) **Ensemble de verrouillage de carte électronique sur un rack**
Verriegelungsvorrichtung für eine Leiterplatte auf einem Baugruppenträger
Locking mechanism for a printed circuit board on a rack.

(30) Priorité: 15.04.2009 FR 0952459
(43) Date de publication de la demande: 20.10.2010
(73) Titulaire: RADIALL, 93116 Rosny-Sous-Bois (FR)
(72) Inventeur: Van Der Mee, Marnix, 37270 Montlouis sur Loire (FR); Alexandre, Renaud, 37530 Montreuil en Touraine (FR); Becavin, Patrice, 37110 Auzouer-en-Touraine (FR)
(74) Mandataire: Leszczynski, André

(56) Documents cités:
- EP-A1- 0 780 932
- EP-A1- 1 499 171
- FR-A1- 2 733 658
- US-A1- 2002 090 851
- US-A1- 2005 117 316

## Description

La présente invention a pour objet un système de positionnement et de verrouillage de carte électronique sur un rack.

L'invention s'applique plus particulièrement au positionnement et au verrouillage de cartes électroniques sur rack dans le domaine de l'aéronautique, notamment pour des baies et racks avioniques.

Il est connu d'utiliser des cartes électroniques filles connectées à l'une de leurs extrémités à une ou plusieurs cartes mères et/ou à des connecteurs isolés raccordés à un câblage.

La connectique de fond de rack est par exemple composée d'un ou plusieurs connecteurs et le positionnement et le verrouillage de la connexion entre cartes filles d'une part et connecteurs de fond de rack d'autre part peut s'effectuer de différentes manières.

Le ou les connecteurs de fond de rack peuvent être fixés de façon rigide sur le rack ou être flottants en transverse et/ou axiale, afin de rattraper des défauts de position.

Dans une autre variante connue, le flottement axial des connecteurs est assuré par un élément élastique compensant les différences de profondeur entre connecteurs de fond de rack.

Dans une autre variante connue, le guidage transverse est fourni par le connecteur lui-même sous forme de rainures et de bossage, coulissant les uns dans les autres.

Le guidage transverse peut encore être assuré indépendamment des connecteurs, à l'aide de doigts de centrage métallique.

Le verrouillage des cartes sur le rack peut encore être réalisé au niveau du connecteur de fond de rack, par l'intermédiaire de clips, d'épingles élastiques, de vis ou de leviers.

En variante, le verrouillage des cartes peut être déporté au niveau de la carte électronique et de la structure du rack, des leviers de verrouillage étant par exemple installés directement sur un circuit imprimé de la carte électronique ou des vis de verrouillage étant en variante intégrées au châssis supportant ledit circuit imprimé.

Les solutions de connecteurs de fond de rack avec flottement connues présentent généralement comme défaut un décollement du connecteur par rapport à la platine de fond de rack, ce décollement induisant la présence d'interstices qui favorisent les fuites d'interférences électromagnétiques.

Par ailleurs, un système de verrouillage de la carte électronique fille sur le rack intégré à un connecteur de fond de rack peut présenter comme un inconvénient le fait d'être peu accessible pour la déconnexion, de ne pas offrir une bonne visibilité de la bonne connexion, de ne pas gérer les problèmes de profondeur d'accouplement lorsque plusieurs connecteurs sont montés sur une même carte électronique, ou encore de ne pas permettre de rigidifier la carte électronique entière, ce qui peut poser un problème par rapport à la tenue aux vibrations de la carte électronique dans des applications en environnement sévère, et ne pas permettre de monter dans un ordre indifférent les connecteurs de fond de rack et la carte électronique.

Par ailleurs, il est encore connu d'utiliser pour verrouiller la carte électronique sur le rack des techniques dites "externes", consistant à combiner un verrouillage longitudinal par vissage et un verrouillage transversal par glissière à prisme, par exemple de type Calmark ®.

Un verrouillage par vissage simple ne permet pas directement le rattrapage des jeux longitudinaux dans le cas d'une connectique multiple coté rack et ne permet pas de maitriser simplement l'effort d'accouplement de la connectique. Ces deux inconvénients doivent alors être palliés par la connectique côté fond de rack. Par ailleurs, les systèmes de glissière à prisme ne permettent pas de vaincre des forces d'accouplement permanentes.

Pour remédier à ces inconvénients, il a été proposé d'une part d'introduire un flottement selon l'axe de connexion sur plusieurs connecteurs situés sur le fond de rack, ce flottement étant assuré par un élément élastique telle qu'une rondelle élastique ou un ressort hélicoïdal.

Néanmoins, un tel système de flottement peut nécessiter des éléments élastiques de forte raideur et avec des valeurs de déplacement de l'ordre de plusieurs millimètres. Des ressorts répondant à ces conditions sont relativement encombrants par rapport aux dimensions des connecteurs.

En outre, l'intégration des éléments élastiques dans les connecteurs de fond de rack peut rendre ces derniers plus complexes, conduisant à une augmentation des dimensions des platines de connecteur pour loger les éléments élastiques et le système de retenue des ressorts.

Enfin, le flottement des connecteurs dans le rack peut introduire une absence d'appui physique entre ces connecteurs et la platine métallique de fond de rack, créant des ouvertures conduisant à des fuites d'interférences électromagnétiques (encore appelées EMI en anglais).

En outre, il a également été proposé d'utiliser pour réaliser le verrouillage de la carte électronique sur le rack des systèmes de leviers positionnés sur la carte électronique, permettant d'insérer la carte électronique sur le rack.

Néanmoins, de tels systèmes de verrouillage ne fournissent pas une compensation permanente des forces tendant à la déconnexion, ces forces étant générées par les systèmes d'étanchéité, et ces systèmes de verrouillage ne peuvent permettre de compenser des jeux longitudinaux trop élevés.

La demande US 2002/0090851 divulgue un organe de verrouillage d'une carte électronique sur un châssis d'un fond de panier, l'organe de verrouillage comportant au moins un élément de précontrainte élastique.

I1 existe un besoin pour répondre à tout ou partie des inconvénients précités.

L'invention a pour objet de répondre à ce besoin et elle y parvient, selon l'un de ses aspects, grâce à un ensemble de verrouillage d'au moins une carte électronique sur un rack, selon la revendication 1.

L'invention permet entre autres de compenser des efforts permanents entre la carte électronique et le rack.

L'élément de précontrainte élastique est avantageusement reçu dans un logement ménagé dans le chariot et ledit logement comporte avantageusement des reliefs définissant une butée avant et une butée arrière pour la compression de l'élément de précontrainte élastique dans le chariot, de tels reliefs permettant par exemple de contrôler la compression de l'élément de précontrainte élastique dans le chariot.

L'élément de précontrainte élastique est avantageusement disposé en partie ou en totalité à l'intérieur du chariot, étant notamment différent d'un ressort reliant la carte électronique au chariot et s'étendant à l'extérieur du chariot.

Le chariot comporte avantageusement une zone de verrouillage pour la carte électronique.

La carte électronique comporte avantageusement :
- un circuit imprimé,
- une pièce de structure fixée au circuit imprimé et,
- au moins un organe de verrouillage de la carte électronique agencé pour coopérer avec la zone de verrouillage du chariot, l'organe de verrouillage étant porté par la pièce de structure.

Dans une variante, la carte électronique est dépourvue de pièce de structure et l'organe de verrouillage est porté directement par le circuit imprimé, sans l'intermédiaire de la pièce de structure.

Avec un système de verrouillage selon l'invention, le verrouillage de la carte électronique sur le rack peut être effectué avec ou sans utilisation d'outil standard tel qu'une clé dynamométrique.

L'organe de verrouillage peut par ailleurs être agencé pour permettre de démultiplier l'effort d'accouplement fourni par un opérateur et permettre d'éviter le retour en arrière de la carte électronique sous l'effet des forces exercées en permanence et s'opposant au verrouillage, telles que des forces exercées par des tapis interfaciaux.

Selon un premier exemple de mise en oeuvre du premier mode de réalisation, la zone de verrouillage du chariot comporte avantageusement un taraudage débouchant vers l'extérieur du chariot, la pièce de structure comporte avantageusement une face destinée à venir en appui contre le chariot lorsque la carte électronique est verrouillée sur le rack, ladite face comportant un taraudage, et l'organe de verrouillage comporte avantageusement une vis destinée à être reçue dans le taraudage de ladite face et de la zone de verrouillage du chariot.

La vis est par exemple une vis imperdable reçue dans le taraudage de la pièce de structure et le verrouillage de la carte électronique sur le rack est assuré par le serrage de la vis dans le taraudage du chariot. L'invention permet ainsi un verrouillage et un déverrouillage de la carte sur le rack selon que l'on visse ou l'on dévisse la vis imperdable.

Selon un deuxième exemple de mise en oeuvre du premier mode de réalisation, la zone de verrouillage du chariot comporte avantageusement au moins un rouleau, par exemple monté libre en rotation, et s'étendant transversalement par rapport à l'axe longitudinal du chariot et l'organe de verrouillage comporte avantageusement un levier monté en rotation sur la pièce de structure.

Le chariot comporte par exemple deux rouleaux libres en rotation : un chariot avant et un chariot arrière.

Le rouleau arrière sert par exemple de point d'appui pour insérer la carte électronique lors du verrouillage de celle-ci sur le rack et le rouleau avant sert par exemple de point d'appui lors du déverrouillage de la carte électronique, facilitant l'éjection de celle-ci du rack.

Le ou les rouleaux peuvent également servir à guider en translation le chariot dans le logement ménagé dans la plaque inférieure du rack.

Le levier comporte avantageusement :
- une partie proximale destinée à venir en appui contre le ou les rouleaux lors des opérations de verrouillage ou de déverrouillage de la carte électronique sur le rack,
   et
- une partie distale définissant une partie de préhension pour un utilisateur.

La partie distale du levier fait avantageusement office de bras de levier, permettant de démultiplier l'effort exercé par un utilisateur.

La pièce de structure et la partie distale sont avantageusement configurées pour maintenir le levier sur la pièce de structure dans une position angulaire prédéfinie. Cette position prédéfinie correspond par exemple à la position du levier lorsque la carte électronique est verrouillée sur le rack, ce qui peut permettre d'éviter un déverrouillage intempestif de la carte électronique.

Le rack peut également comporter une plaque supérieure comprenant un logement pour un chariot recevant un deuxième élément de précontrainte élastique, similairement à ce qui a été décrit ci-dessus pour la plaque inférieure du rack.

D'autres avantages et caractéristiques avantageuses apparaîtront à la lecture qui va suivre d'exemples non limitatifs de mise en oeuvre de l'invention et à l'examen du dessin annexé sur lequel :
- les figures 1 à 7 représentent un ensemble de verrouillage selon un premier mode de réalisation de l'invention,
- les figures 8 à 14 représentent un ensemble de verrouillage,
- les figures 15 et 16 représentent une platine de fond de rack,
- la figure 17 représente de façon schématique un rack.

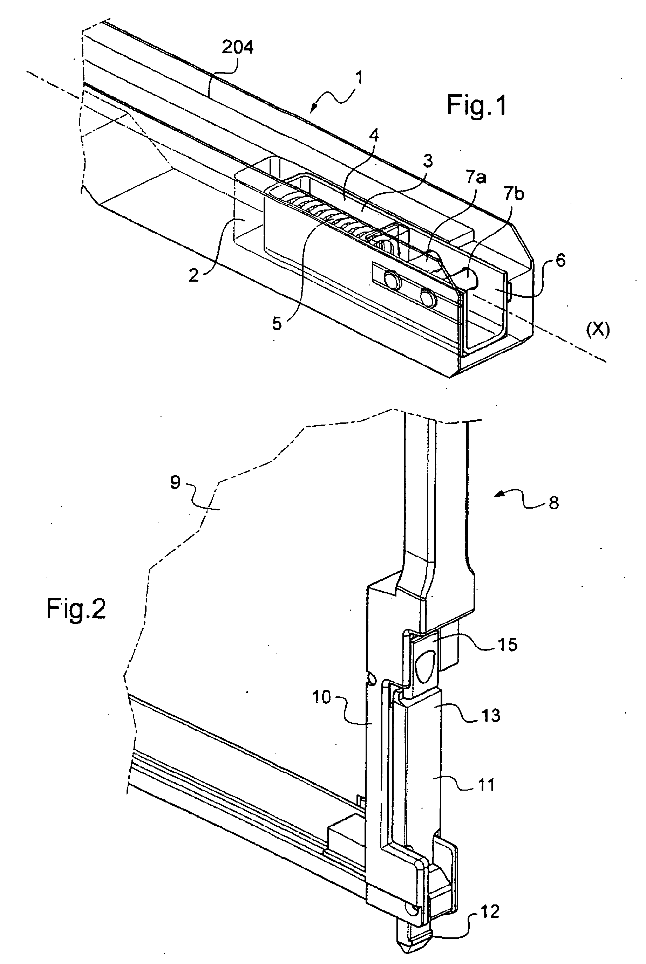

On va décrire en référence aux figures 1 à 7 un premier mode de réalisation d'un ensemble de verrouillage.

Cet ensemble comporte un rack désigné globalement par 1 et une carte électronique désignée globalement par 8.

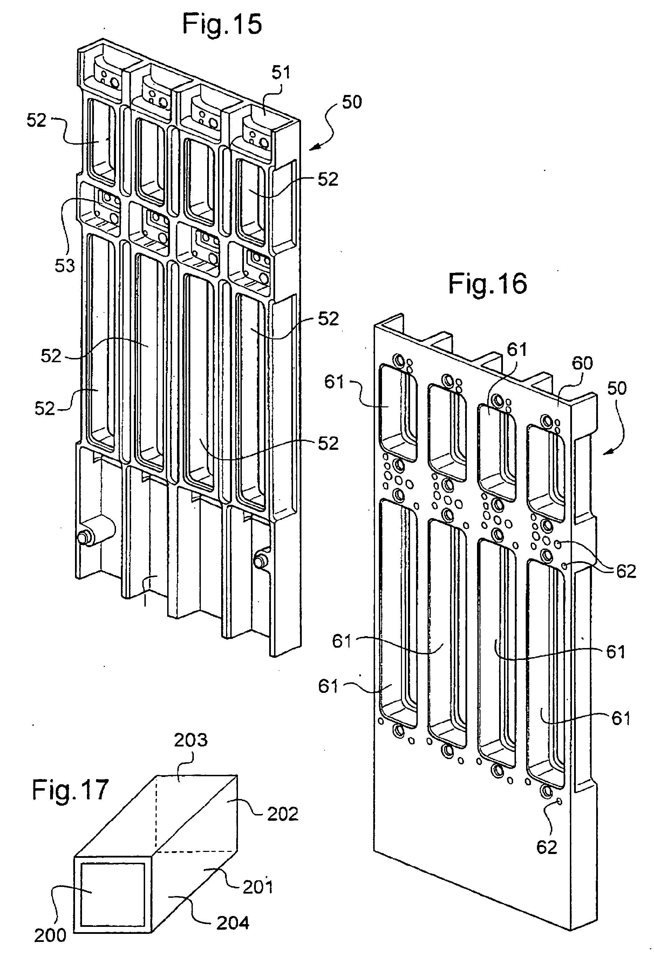

On a représenté de façon schématique à la figure 17 un exemple de rack classique 1. Ce rack comporte une face avant ouverte 200, des joues latérales 201, une plaque de fond 202, encore appelée platine, une plaque supérieure 203 et une plaque inférieure 204. Comme représenté à la figure 1, un logement 2 est ménagé à l'intérieur de la plaque inférieure 204 du rack 1. Un chariot 3, s'étendant selon un axe longitudinal X, est reçu dans le logement 2 de façon mobile dans ce logement selon l'axe X. Le chariot 3 est par exemple réalisé en matière plastique ou métallique, étant par exemple obtenu par moulage, usinage ou découpage-pliage.

Le logement 2 est dans l'exemple décrit ménagé dans la plaque inférieure du rack à proximité de la zone d'entrée d'une carte électronique dans le rack 1 mais l'invention n'est pas limitée à un tel exemple.

Le chariot 3 comporte une partie avant 4 définissant un logement à l'intérieur duquel est reçu un élément de précontrainte élastique 5 qui est dans l'exemple décrit un ressort hélicoïdal.

L'invention n'est pas limitée à un tel exemple d'élément de précontrainte élastique. Dans des variantes non représentées, l'élément de précontrainte élastique est réalisé à l'aide d'un ressort de traction, d'un ressort de torsion, d'un ressort à lame ou encore d'une rondelle élastique.

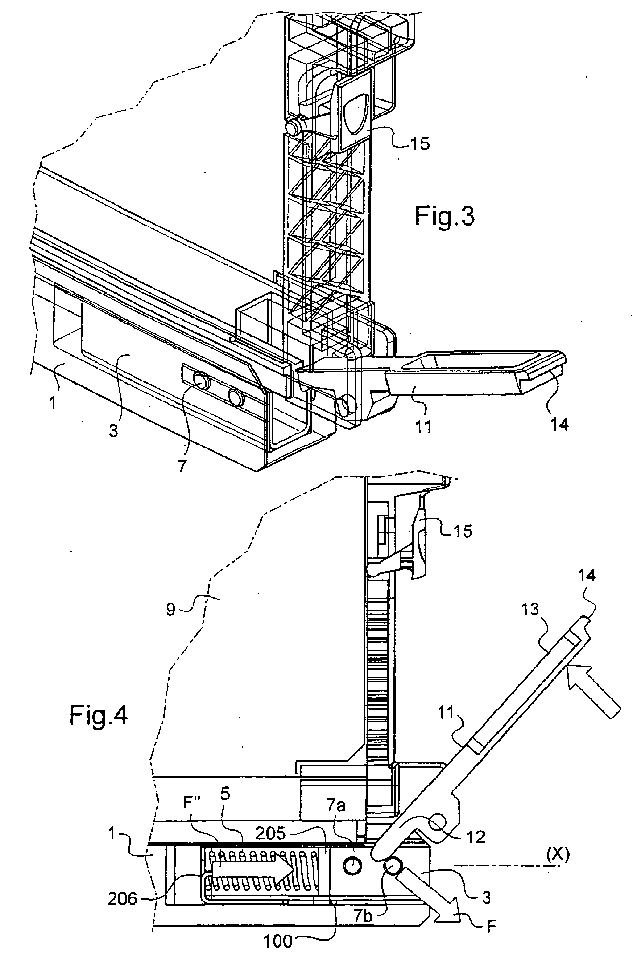

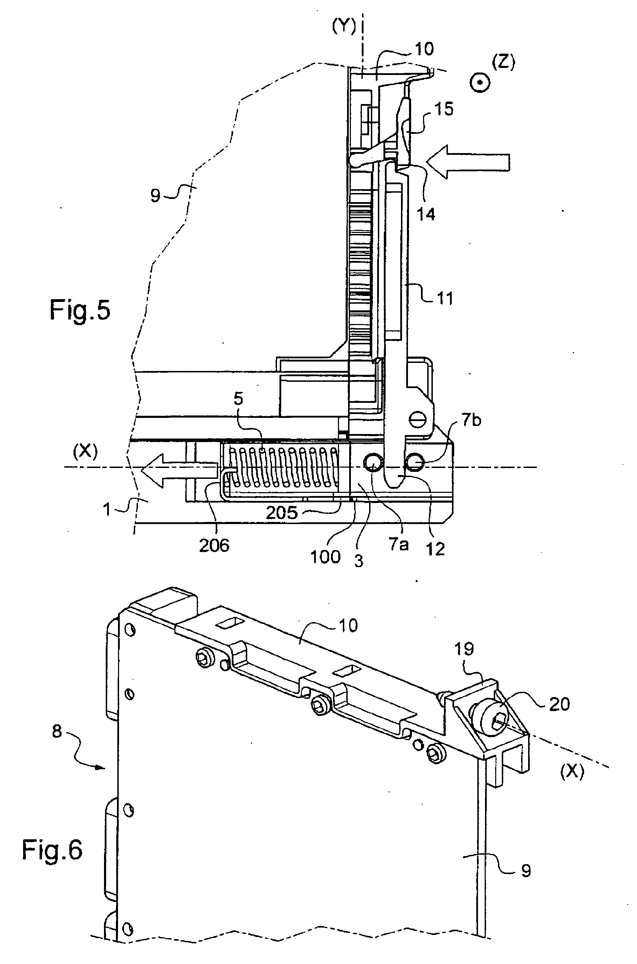

Le déplacement du chariot 3 à l'intérieur du logement 2 selon l'axe X est dans l'exemple décrit limité vers l'avant par une butée 205 formée sur la plaque inférieure du rack et visible sur les figures 4 et 5 et vers l'arrière par la compression de l'élément de précontrainte élastique 5.

En outre, un relief 206 est ménagé dans le chariot 3 de manière à constituer une butée avant pour la compression de l'élément de contrainte élastique 5 dans le chariot 3. La paroi du chariot 3 comporte par ailleurs une ouverture 100 visible sur les figures 3 à 5 et traversée par un élément solidaire du rack 1 et venant constituer une butée arrière pour la compression de l'élément de précontrainte élastique 5.

Le chariot 3 comporte encore dans l'exemple des figures 1 à 7 une partie arrière 6 définissant une zone de verrouillage.

La zone de verrouillage 6 comporte dans l'exemple décrit un rouleau avant 7a et un rouleau arrière 7b potentiellement libres en rotation et s'entendant perpendiculairement par rapport à l'axe X du chariot.

On va maintenant décrire en référence à la figure 2 un exemple de carte électronique 8 destinée à être verrouillée sur le rack 1 représenté à la figure 1.

Cette carte électronique 8 comporte par exemple un circuit imprimé 9 et, dans l'exemple décrit, une pièce de structure 10, encore appelée raidisseur, fixée sur le circuit imprimé et portant un organe de verrouillage 11 et s'étendant selon un axe longitudinal Y.

Dans un autre exemple représenté, l'organe de verrouillage 11 est directement fixé sur le circuit imprimé 9.

Dans l'exemple des figures 1 à 5, l'organe de verrouillage 11 comporte un levier libre en rotation par rapport à la pièce de structure 10.

Ce levier comporte une partie proximale 12 pouvant avoir la forme d'un crochet et une partie distale 13 définissant une partie de préhension pour un opérateur.

La partie distale 13 comporte à son extrémité une languette 14, comme représenté à la figure 3.

La pièce de structure 10 comporte encore dans l'exemple décrit un bouton 15, pouvant coulisser selon l'axe longitudinal Y de la pièce de structure 10 ou pivoter autour d'un axe Z perpendiculaire au plan de la figure 5. Pour le bon fonctionnement du bouton 15 une force de rappel élastique peut être prévue.

Dans l'exemple illustré à la figure 2, le levier est maintenu contre la pièce de structure 10, cette position correspondant à celle du levier lorsque la carte électronique 8 est verrouillée sur le rack 1.

Lors du verrouillage de la carte électronique 8 sur le rack 1, la partie proximale 12 du levier 11 vient en appui contre le rouleau arrière 7b, exerçant une force F sur ce dernier tandis qu'un opérateur exerce une force F', afin d'amener le levier 11 dans la position de verrouillage représentée à la figure 5, dans lequel le levier repose entre les rouleaux 7a et 7b du chariot 3.

Lors de ce déplacement du levier 11, l'élément de précontrainte élastique 5 est mis sous tension, ce qui provoque le déplacement du chariot 3 vers la droite, comme représenté par la flèche F" sur la figure 4.

Comme on peut le voir à la figure 5, le levier est bloqué contre la pièce de structure 10 par coopération entre la languette 14 et le bouton 15.

Lorsqu'un opérateur souhaite déverrouiller la carte électronique 8 du rack 1, il peut appuyer sur le bouton 15 ce qui conduit à libérer la languette 14 et, par conséquent, le levier 11.

L'opérateur peut alors exercer une force sur la partie distale 13 du levier tandis que la partie proximale 12 glisse sur le rouleau avant 7a, permettant d'extraire en tout ou partie la carte électronique 9 du rack 1.

L'invention n'est pas limitée à l'exemple de zone de verrouillage et d'organe de verrouillage qui viennent d'être décrits.

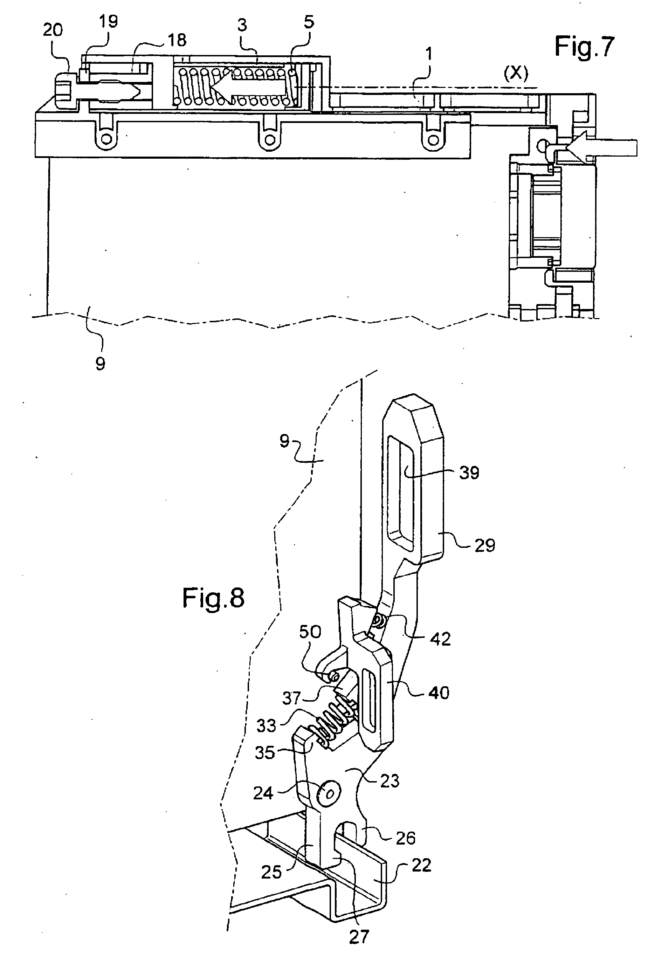

Dans l'exemple de la figure 6, la zone de verrouillage comporte un taraudage 18 représenté à la figure 7, et la pièce de structure 10 comporte une partie en saillie 19, qui s'entend par exemple perpendiculairement à l'axe longitudinal de la pièce de structure 10 qui est dans cet exemple parallèle à l'axe X du chariot 3.

Cette partie en saillie 19 comporte par exemple un taraudage à l'intérieur duquel est vissée une vis imperdable 20 qui constitue un organe de verrouillage. La vis 20 est par exemple rendue imperdable grâce à une partie lisse ménagée sous la tête de vis et présentant un diamètre inférieur au diamètre du taraudage de la partie en saillie 19.

Lors du verrouillage de la carte électronique 8 sur le rack 1, la vis imperdable 20 est vissée dans le taraudage 18 du chariot 3 et la face en saillie 19 vient en appui contre le chariot mobile 3.

Lorsque l'on accouple les connecteurs de carte et les connecteurs fond de panier, c'est-à-dire les connecteurs venant par exemple de l'extérieur, l'effort nécessité pour cet accouplement est développé par l'élément de précontrainte élastique 5 du chariot 3.

Pour déverrouiller la carte électronique 8 du rack 1, l'utilisateur peut dévisser la vis imperdable.

Dans une variante non représenté la vis est emprisonnée dans la pièce 19 par un autre moyen et permet d'assister l'extraction de la carte.

Dans un autre exemple non représenté, la plaque supérieure 203 du rack 1 comporte également un logement 2 pour un chariot 3 recevant un élément de précontrainte élastique 5, similairement à ce qui a été décrit en référence à la plaque inférieure, pour coopérer avec un deuxième organe de verrouillage de la carte électronique 8, similaire à celui décrit ci-dessus.

On va maintenant décrire en référence aux figures 8 à 14 un ensemble de verrouillage.

Dans l'exemple de la figure 8, la carte électronique 8 est destinée à être verrouillée par coopération entre un organe de verrouillage porté par la carte électronique 8 et une rainure 22 ménagée sur la plaque inférieure 204 du rack 1 et définissant une zone de verrouillage.

La carte électronique comporte dans l'exemple décrit un circuit imprimé 9.

L'organe de verrouillage comporte par exemple un levier 23 monté en rotation sur la carte électronique 8 par l'intermédiaire d'une vis 24.

Le levier 23 est dans l'exemple décrit monté directement sur le circuit imprimé 9 mais, dans une variante non représentée, la carte électronique 8 comporte une pièce de structure, par exemple similaire à celle décrite en référence aux figures 1 à 7, et le levier 23 est fixé sur le circuit imprimé 9 par l'intermédiaire de ladite pièce de structure.

Le levier 23 comporte dans l'exemple illustré deux doigts 25 et 26 destinés à venir au contact de la rainure 22. Le doigt 25 présente dans l'exemple décrit une extrémité recourbée 27.

L'organe de verrouillage comporte encore dans l'exemple décrit une palette de préhension 29 qui est articulée sur le levier 23 par une double liaison.

Le levier 23 et la palette de préhension 29 sont reliés d'une part par une liaison pivot via une vis 30 et d'autre part par l'intermédiaire d'un élément de précontrainte élastique 33, qui est dans l'exemple décrit un ressort hélicoïdal mais qui pourrait également être dans d'autres exemples de réalisation un ressort de traction, un ressort de torsion, un ressort à lame ou encore une rondelle élastique.

La double liaison entre la palette de préhension 29 et le levier 23 permet d'obtenir une articulation entre ces deux éléments offrant un débattement angulaire limité.

Le levier 23 comporte, à son extrémité opposée au doigt 25 et 26, une zone 35 comportant des moyens d'appui et de centrage de l'élément de précontrainte élastique 33.

La palette de préhension comporte par ailleurs une zone 37 d'appui pour l'élément élastique de précontrainte 33 permettant le guidage et le maintien en position de cet élément de précontrainte élastique 33.

Les zones 35 et 37 sont par exemple obtenues par un lamage cylindrique emprisonnant une extrémité du ressort. La palette de préhension 29 peut également comporter une zone de préhension 39, compatible avec la prise en main par un utilisateur.

L'organe de verrouillage représenté à la figure 8 comporte encore un crochet de blocage 40 articulé sur la palette de préhension 29.

Ce crochet 40 est relié d'une part à la palette de préhension 29 par une liaison pivot via une vis 41 et d'autre part par l'intermédiaire d'un deuxième élément de précontrainte élastique 42.

Cette double liaison permet d'obtenir une articulation entre le crochet de blocage 40 et la palette de préhension 29 présentant un débattement angulaire limité.

Le crochet de blocage 40 peut comporter une portion 44 ayant une forme recourbée et dont le rôle sera décrit par la suite.

Le crochet 40 comporte encore une zone 45 définissant une partie de préhension pour un utilisateur.

Dans l'exemple représenté, la carte électronique 8 comporte un pion de crochetage 50. Ce pion de crochetage 50 peut être, comme décrit, directement fixé sur le circuit imprimé 9 ou, en variante, être intégré à une pièce de structure fixée sur le circuit imprimé 9.

On va maintenir décrire un exemple de verrouillage d'une carte électronique 8 sur un rack 1 à l'aide du système de verrouillage décrit en référence aux figures 8 à 14.

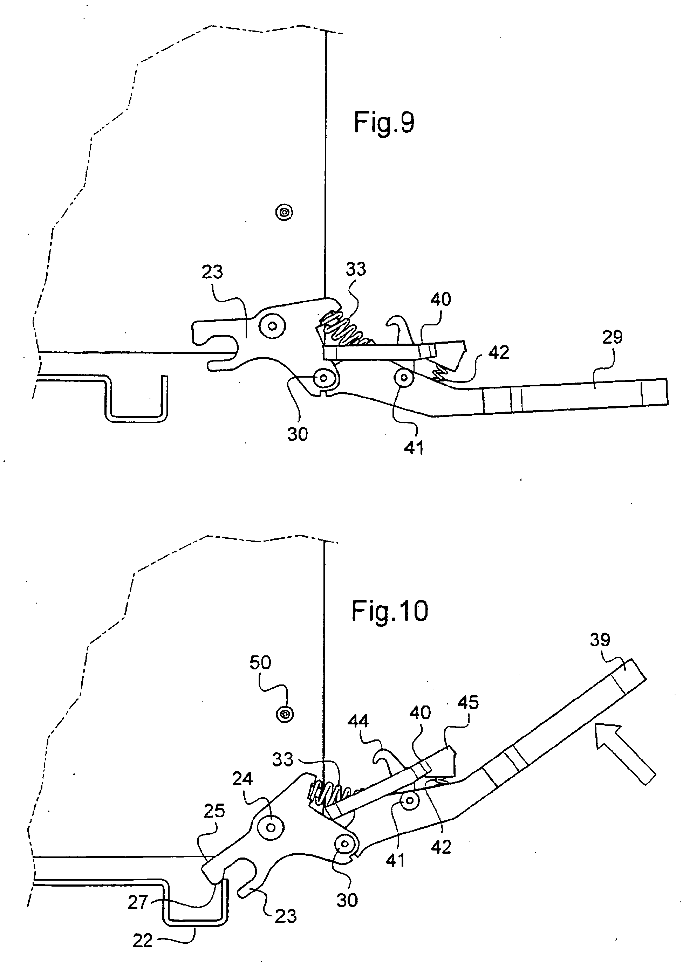

Lors de l'engagement de la carte électronique 8 dans la rainure 22 du rack 1, l'opérateur pousse, comme représenté sur la figure 10, sur la palette de préhension 29.

Cette force est transmise par l'élément de précontrainte élastique 33 au levier 23 et entraîne la rotation de ce dernier par rapport à la carte électronique 8 autour de l'axe défini par la vis 24. Du fait de la rotation du levier 23, le doigt 25 s'engage dans la rainure 22 et exerce un effort sur un bord de cette rainure faisant avancer la carte électronique 8 vers le fond de rack.

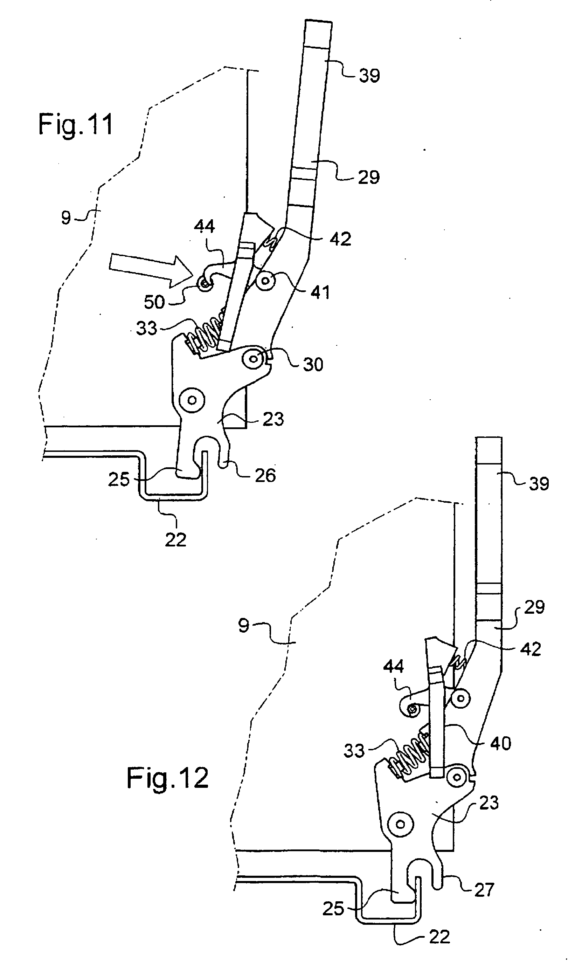

Lors de la rotation du levier 23, le crochet de blocage 40 rencontre puis contourne le pion de crochetage 50, comme représenté à la figure 11, puis s'accroche au pion de crochetage par sa portion recourbée 44, comme représenté à la figure 12.

Dans la position représentée à la figure 12, la palette de préhension 29 ne peut plus revenir en arrière relativement à la carte électronique 8. Par réaction, l'élément de précontrainte élastique 33 exerce un effort sur le levier de verrouillage 23, cet effort étant alors retransmis vers le rack 1 par l'intermédiaire du doigt 25. Un effort permanent de la carte électronique 8 vers le fond de rack est alors exercé, afin d'assurer une pression permanente sur la connectique.

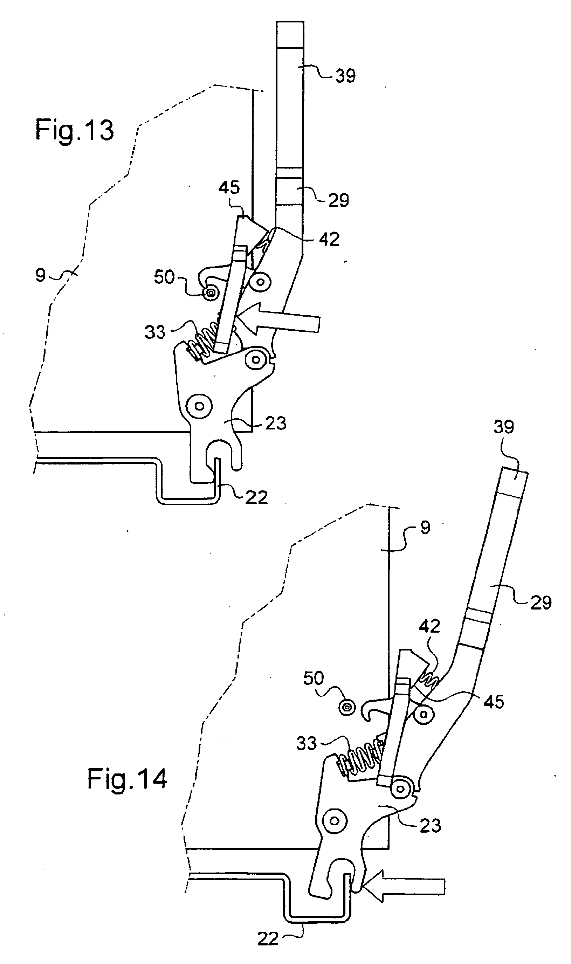

Lors d'une opération de déverrouillage, l'utilisateur exerce une pression sur la zone d'appui 45 du crochet de blocage 40, ce qui libère le crochet de blocage 40 du pion de crochetage 50. Du fait de l'action de l'élément de précontrainte élastique 42, la palette de préhension 29 pivote en arrière. L'utilisateur peut alors se saisir de cette palette de préhension et, en tirant dessus, extraire la carte électronique 8 du rack 1, cette extraction étant par exemple favorisée par la force exercée par le doigt 26 du levier de verrouillage 23 sur le bord de la rainure 22, repoussant ainsi la carte électronique 8 vers l'arrière, comme représenté à la figure 14.

Dans une variante, une zone de verrouillage similaire à celle ménagée sur la plaque inférieure 204 est ménagée sur la plaque supérieure 203 du rack, pour coopérer avec un deuxième organe de verrouillage porté par la carte électronique 8 et similaire à celui coopérant avec la zone de verrouillage 22 de la plaque inférieure 204 et décrit en référence aux figures 8 à 14.

On va maintenant décrire en référence aux figures 15 et 16 un exemple de platine de fond de rack 202.

Cette platine comporte une face avant 51 représentée à la figure 15.

Cette face avant 51 comporte dans l'exemple décrit une pluralité de cavités creuses 52 permettant de centrer les cavités de connecteurs de carte dans la direction transverse.

La face avant comporte par exemple deux rangées de cavités, chaque rangée de cavités présentant la même taille.

La face avant 51 comporte également des zones de détrompage 53 étant par exemple des pions ou des clés de codage.

La face avant 51 comporte encore dans l'exemple décrit une zone 54 de fixation pour une carte mère.

La face avant 51 définit par exemple un plan d'appui selon la direction axiale, permettant aux connecteurs de carte d'être plaqués contre ce plan d'appui afin de refermer les cavités 52 de la platine, permettant ainsi de lutter contre les fuites d'interférences électromagnétiques.

On va maintenant décrire en référence à la figure 16, un exemple de face arrière 60 d'une platine métallique de fond de rack.

Une pluralité de cavités 61 est dans l'exemple décrit ménagée sur cette face arrière 60 afin de recentrer transversalement les connecteurs câblés de fond de rack. Le recentrage s'effectue par exemple sur les faces externes d'une ou plusieurs des cavités d'un connecteur câblé.

Ces cavités 61 se présentent par exemple sous la forme de rangées, des cavités appartenant à des rangées différentes ayant par exemple des tailles distinctes.

La face arrière 60 comporte également des moyens de détrompage 62 qui sont dans l'exemple décrit des trous pour pions de détrompage.

Cette face arrière 60 définit avantageusement un plan d'appui selon la direction axiale permettant aux connecteurs de fond de rack, une fois fixés, d'être plaqués contre la platine et de refermer les cavités de la platine contre les fuites d'interférences électromagnétiques.

Une platine et un ensemble de verrouillage tels que décrits ci-dessus permettent avantageusement d'assurer un centrage transversal entre connecteurs qui soit satisfaisant, de rattraper les jeux axiaux des connecteurs, d'assurer un blindage contre les interférences électromagnétiques qui soit satisfaisant et de compenser les efforts permanents de connexion.

L'invention n'est pas limitée aux exemples qui viennent d'être décrits.

Dans les revendications, l'expression "comportant un" doit être comprise comme "comportant au moins un" sauf si le contraire est spécifié.

## Revendications

1. Ensemble de verrouillage d'au moins une carte électronique (8) sur un rack (1) comportant :
- au moins une carte électronique (8),
- un rack (1) comportant une plaque inférieure (204) comprenant au moins un logement (2), et
- un système de verrouillage de la carte sur le rack,
**caractérisé par le fait que** le système de verrouillage comprend au moins un chariot (3) s'étendant selon un axe longitudinal (X) et mobile dans le logement (2) et **par le fait que** le système de verrouillage comporte au moins un élément de précontrainte élastique (5) de la carte électronique (8) lorsque celle-ci est fixée sur le rack (1), l'élément de précontrainte élastique (5) étant reçu dans le chariot (3).

2. Ensemble selon la revendication 1, **caractérisé par le fait que** l'élément de précontrainte élastique (5) est reçu dans un logement (4) ménagé dans le chariot (3) et **par le fait que** ledit logement (4) comporte des reliefs définissant une butée avant et une butée arrière pour la compression de l'élément de précontrainte élastique (5) dans le chariot (3).

3. Ensemble selon la revendication 1 ou 2, **caractérisé par le fait que** le chariot (3) comporte une zone de verrouillage (6) pour la carte électronique (8).

4. Ensemble selon la revendication 3, **caractérisé par le fait que** la carte électronique (8) comporte :
- un circuit imprimé (9),
- une pièce de structure (10) fixée au circuit imprimé (9) et,
- au moins un organe de verrouillage (11) de la carte électronique (8) sur la zone de verrouillage (6) du chariot (3), l'organe de verrouillage (11) étant porté par la pièce de structure (10).

5. Ensemble selon la revendication 4, **caractérisé par le fait que** là zone de verrouillage (6) comporte un taraudage (18) débouchant vers l'extérieur du chariot, **par le fait que** la pièce de structure (10) comporte une face (19) destinée à venir en appui contre le chariot (3) lorsque la carte électronique (8) est verrouillée sur le rack (1), ladite face (19) comportant un taraudage, et par lé fait que l'organe de verrouillage (11) comporte une vis (20) destinée à être reçue dans le taraudage de ladite face (19) et de la zone de verrouillage (6).

6. Ensemble selon la revendication 5, **caractérisé par le fait que** la zone de verrouillage (6) comporte au moins un rouleau (7a, 7b) s'étendant transversalement à l'axe longitudinal (X) du chariot (3) et **par le fait que** l'organe de verrouillage (11) comporte un levier monté en rotation sur la pièce de structure.

7. Ensemble selon la revendication 6, **caractérisé par le fait que** le levier comporte une partie proximale (12) destinée à venir en appui contre le rouleau (7a, 7b) lorsque la carte électronique (8) est verrouillée sur le rack (1) et une partie distale (13) définissant une partie de préhension.

8. Ensemble selon la revendication 7, **caractérisé par le fait que** la pièce de structure (10) et la partie distale (13) sont configurées pour maintenir le levier sur la pièce de structure (10) dans une position angulaire prédéfinie.

## Claims

1. A locking assembly of at least one electronics card (8) on a rack (1), comprising:
at least one electronics card (8);
a rack (1) having bottom plate (204) at least one housing (2); and
a locking system of the card on the rack,
**characterized in that** the locking system comprises at one carriage (3) in at extending along a longitudinal axis and movable in the lousing (2), and **in that** the locking system includes at least one resilient prestress element (5) of the electronics card (8) when it is fastened to the rack (1), the resilient prestress element (5) being received in the carriage (3).

2. An assembly according to claim 1, **characterized in that** the resilient prestress element (5) is received in a housing (4) formed in the carriage (3), and **in that** said housing (4) includes portions in relief defining and rear abutments for compressing the resilient prestress element (5) in the carriage (3).

3. An assembly according to claim 1, **characterized in that** the carriage (3) includes a locking zone (6) for the electronics card (8).

4. An assembly according to claim 3, **characterized in that** the electronics card (8) comprises:
a printed circuit (9);
a structural part (10) fastened to the printed circuit (9); and
at least one locking member (11) of the electronics card (8) on the locking zone (6) of the carriage (3), the locking member (11) being carried by the structural part (10).

5. An assembly according to claim 4, **characterized in that** the locking zone (6) includes a tapping (18) opening to the outside of the carriage, in the structural part (10) includes a face (19) for bearing against the carriage (3) when the electronics card (8) is locked on the rack (1), said face (19) including a tapping, and **in that** the locking member (11) comprises a screw (20) configured to be received in the tapping in said face (19) and in the locking zone (6).

6. An assembly according to claim 5, **characterized in that** the locking zone (6) comprises at least one roller (7a, 7b) extending transversely to the longitudinal axis of the carriage (3), and **in that** the locking member (11) comprises a lever pivotally mounted on the structural part.

7. An assembly according to claim 6, **characterized in that** the lever has a proximal potion (12) for bearing against the roller (7a, 7b) when the electronics card (8) is locked on the rack (1), and a distal portion (13) defining a grip portion.

8. An assembly according to claim 7, **characterized in that** the structural part (10) and the distal portion (13) are configured to hold the lever on the structural part (10) in a predefined angular position.

## Patentansprüche

1. Vorrichtung zur Verriegelung wenigstens einer elektronischen Leiterplatte (8) auf einem Baugruppenträger (1), mit:
- wenigstens einer elektronischen Leiterplatte (8),
- einem Baugruppenträger (1), der eine untere Platte (204) mit wenigstens einer Aufnahme (2) aufweist, und
- einem System zur Verriegelung der Leiterplatte auf dem Baugruppenträger,
**dadurch gekennzeichnet, dass** das System zur Verriegelung wenigstens einen Wagen (3) aufweist, der sich in Richtung einer Längsachse (X) erstreckt und in der Aufnahme (2) beweglich ist, und dass das System zur Verriegelung wenigstens ein Element (5) aufweist, das zur elastischen Vorspannung der elektronischen Leiterplatte (8) dient, wenn diese auf dem Baugruppenträger (1) befestigt ist, wobei das elastische Vorspannungselement (5) in dem Wagen (3) aufgenommen ist.

2. Vorrichtung nach Anspruch 1, **dadurch gekennzeichnet, dass** das Element (5) zur elastischen Vorspannung in einer Aufnahme (4) aufgenommen ist, die in dem Wagen (3) ausgebildet ist, und dass die genannte Aufnahme (4) Reliefs hat, die einen vorderen Anschlag und einen hinteren Anschlag für die Kompression des elastischen Vorspannungsdements (5) in dem Wagen (3) definieren.

3. Vorrichtung nach Anspruch 1 oder 2, **dadurch gekennzeichnet dass** der Wagen (3) eine Verriegelungszone (6) für die elektronische Leiterplatte (8) aufweist.

4. Vorrichtung nach Anspruch 3, **dadurch gekennzeichnet, dass** die elektronische Leiterplatte (8) aufweist:
- eine gedruckte Schaltung (9),
- ein Strukturteil (10), das an der gedruckten schaltung (9) befestigt ist und
- wenigstens ein Organ (11) zur Verriegelung der elektronischen Leiterplatte (8) auf der Verriegelungszone (6) des Wagens (3), wobei das Verriegelungsorgan (11) an dem Strukturteil (10) gehalten ist.

5. Vorrichtung nach Anspruch 4, **dadurch gekennzeichnet, dass** die Verriegelungszone (6) eine sich zur Außenseite des Wagens öffnende Gewindebohrung (18) aufweist, das Strukturteil (10) eine Fläche (19) aufweist, die dazu bestimmt ist, an dem Wagen (3) in Anlage zu kommen, wenn die elektronische (8) auf dem Baugruppenträger (1) verriegelt ist, wobei die genannte Fläche (19) eine Gewindebohrung aufweist, und dass das Verriegelungsorgan (11) eine Schraube (20) aufweist, die dazu bestimmt ist, in der Gewindebohrung der genannten Fläche (19) und der Verriegelungszone (6) aufgenommen zu werden.

6. Vorrichtung nach Anspruch 5, **dadurch gekennzeichnet, dass** die Verriegelungozone (6) wenigstens eine Walze (7a, 7b) aufweist, die sich quer zu der Längsachse (X) des Wagens (3) erstreckt, und dass das Verriegelungsorgan (11) einen Hebel aufweist, der drehbar an dem Strukturteil montiert ist.

7. Vorrichtung nach anspruch 6, **dadurch gekennzeichnet, dass** der Hebel einen FußabschäU (12) aufweist, der dazu bestimmt ist, an der Walze (7a, 7b) in Anlage zu kommen, wenn die elektronische Leiterplatte (8) auf dem Baugruppenträger (1) verriegelt ist, sowie einen Endabschnitt (13), der einen Griff bildet.

8. Vorrichtung nach Anspruch 7, **dadurch gekennzeichnet, dass** das Strukturteil (10) und der Endabschnitt (13) so ausgebildet sind, dass sie den Hebel in einer vordefinierten Winkelstellung an dem Strukturteil (10) halten.
